# EUROPÄISCHE PATENTSCHRIFT

(11) **EP 2 498 283 B1**
(45) Veröffentlichungstag und Bekanntmachung des Hinweises auf die Patenterteilung: **16.05.2018**
(21) Anmeldenummer: 12154199.9
(22) Anmeldetag: 07.02.2012
(51) Int. Cl.: H01L 21/48, H01L 23/373

(54) **Verfahren zur Herstellung eines Leistungshalbleitersubstrates**
Method for manufacturing a power-semiconductor substrate
Procédé de fabrication de substrat semi-conducteur de puissance

(30) Priorität: 10.03.2011 DE 102011005322
(43) Veröffentlichungstag der Anmeldung: 12.09.2012
(73) Patentinhaber: SEMIKRON Elektronik GmbH & Co. KG, 90431 Nürnberg (DE)
(72) Erfinder: Dr. Besendörfer, Kurt-Georg, 90556 Cadolzburg (DE); Erdner, Nadja, 91227 Leinburg (DE)

(56) Entgegenhaltungen:
- EP-A2- 1 599 078
- DE-A1-102007 022 337
- DE-B3-102006 033 073
- US-A- 5 407 511

## Beschreibung

Die Erfindung betrifft ein Verfahren zur Herstellung eines Leistungshalbleitersubstrates, das einen isolierenden Grundkörper und mindestens eine Leiterbahn aufweist.

Bekannte Leistungshalbleitersubstrate sind beispielhaft als DCB- (direct copper bonding), AMB- (active metal braze) oder IMS- (insulated metal substrate) Substrate ausgebildet. Die mindestens eine Leiterbahn dient zur elektrisch leitenden Verbindung vorzugsweise von Leistungshalbleiterbauelementen. Bei der elektrisch leitenden Verbindung zwischen der Leiterbahn und dem Leistungshalbleiterbauelement kann es sich um eine Lötverbindung oder um eine druckkontaktierte Verbindung handeln.

DCB- Substrate sind beispielhaft aus der US 4 563 383 bekannt; sie weisen einen Grundkörper aus einer Industriekeramik, wie Aluminiumoxid oder Aluminiumnitrit auf. Die hierauf angeordneten Leiterbahnen bestehen aus einer Kupferfolie.

Aus der DE 10 2007 022 337 A1 ist ein Leistungshalbleitersubstrat mit einem elektrisch isolierenden, flächigen Grundkörper bekannt, wobei auf mindestens einer Hauptfläche des Grundkörpers mindestens eine Schichtfolge aus einer dünnen Haftvermittlerschicht, einer Sintermetallschicht und einer Leiterschicht angeordnet ist. Das Verfahren zur Herstellung dieses Leistungshalbleitersubstrates weist die folgenden Verfahrensschritte auf:
- Beschichten mindestens einer Teilfläche mindestens einer Hauptfläche des flächigen Grundkörpers mit einer Haftvermittlerschicht;
- Anordnen einer pastösen Schicht aus dem Sintermetall und einem Lösungsmittel, d.h. einer Sinterpaste, auf einer Teilfläche oder auf der gesamten Fläche der Haftvermittlerschicht;
- Anordnen der Leiterschicht auf der Sintermetallschicht; und
- Druckbeaufschlagung der Leiterschicht des Leistungshalbleitersubstrates.

Die DE 10 2004 019 567 B3 offenbart ein Verfahren zur Befestigung von elektronischen Bauelementen, insbesondere von Leistungshalbleiterbauelementen, wie Dioden, Transistoren oder Thyristoren, auf einem Substrat durch Drucksintern, mit den Verfahrensschritten:
- Aufbringen einer aus einem Metallpulver und einem Lösungsmittel bestehenden pastösen Schicht, d.h. einer Sinterpaste, auf eine Trägerfolie;
- Trocknen der Sinterpaste;
- Anbringen mindestens eines Bauelementes auf die getrockneten Schicht aus der Sinterpaste;
- Beaufschlagung des Verbundes aus dem mindestens einen Bauelement und der die getrocknete Sinterpaste aufweisenden Trägerfolie, wodurch die Haftkraft zwischen der getrockneten Sinterpaste-Schicht und dem Bauelement größer wird als die Haftkraft zwischen der Sinterpaste-Schicht und der Trägerfolie;
- Entfernen der Trägerfolie von dem Gebilde aus dem mindestens einen Bauelement und der daran haftenden Sinterpaste-Schicht;
- Positionieren des Gebildes aus dem mindestens einen Bauelement und der daran haftenden Sinterpaste-Schicht auf dem Substrat; und
- Druckbeaufschlagung der Anordnung, bestehend aus dem Substrat und dem mindestens einen Bauelement mit der daran haftenden Sinterpaste-Schicht zur Sinterverbindung des Substrates mit dem mindestens einen Bauelement.
Diese zuletzt genannte Verfahren dient zur Befestigung elektronischer Bauelemente auf einem Substrat durch Drucksintern, das einer rationellen und zumindest teilweise parallelen Verarbeitung einer Anzahl Bauelemente zugänglich ist, sowie eine strukturierte Ausgestaltung der Sinterschicht ermöglicht.

Ein aus dem Stand der Technik bekanntes Verfahren zur Herstellung eines Leistungshalbleitersubstrates ist in US5407511 beschrieben.

Es ist bekannt, Sinterverbindungen über siebgedruckte oder über schablonengedruckte Verbindungsflächen herzustellen. Hierbei wird die Sinterpaste auf einen der beiden Fügepartner, d.h. das Substrat oder die Leiterbahn, aufgetragen. Anschließend erfolgt eine Drucksinterverbindung. Insbesondere bei Abweichungen von einem vorgegebenen Großformat ist für einen maschinellen Pastendruck eine geeignete Aufnahme erforderlich. Dabei ist jedoch nicht zuverlässig ausschließbar, dass sich der Pastendruck trotz einer solchen Aufnahme schwierig gestaltet, weil die Aufnahmen oftmals nicht innerhalb eines vorgegebenen Toleranzbereiches transportiert werden können, so dass ein automatisierter Druck der Sinterpaste nicht möglich ist.
Dieser Problematik kann zwar eine Preformfolie Abhilfe schaffen, die zwischen die Fügepartner eingelegt wird. Das Positionieren gestaltet sich jedoch auch hierbei schwierig. Preformfolien eignen sich außerdem nicht für komplizierte Geometrien. Mit den gegebenen Mitteln ist es insbesondere nicht möglich, einen Fügepartner ohne Vorsinterschritt beidseitig zu bedrucken. Nach dem Drucken einer Schicht aus Sinterpaste auf einen Fügepartner, d.h. ein Bauteil, ist es erforderlich, das entsprechende Bauteil vorzusintern. Daran anschließend kann dann die gegenüberliegende andere Seite des Bauteils bedruckt werden. Auf diese Weise ist jedoch stets eine Seite bereits vorgesintert, während sich die gegenüberliegende andere Seite noch in einem getrockneten Zustand der Sinterpaste befindet. Das solchermaßen gegebene Gebilde ist folglich nur schwierig zu handhaben. Um diesem Problem abzuhelfen, ist ein zweiter Vorsinter- Verfahrensschritt erforderlich, wodurch jedoch die zuerst vorgesintete Schicht in ihrer Sinteraktivität eingeschränkt wird.

Der Erfindung liegt die Aufgabe zugrunde, ein Verfahren zur Herstellung eines Leistungshalbleitersubstrates mit oder ohne hierauf angeordnete Leistungshalbleiterbauelemente zu schaffen, wobei die oben beschriebenen Mängel auf wirksame Weise beseitigt sind.

Diese Aufgabe wird erfindungsgemäß durch die Merkmale des Anspruches 1 gelöst. Bevorzugte Aus- bzw. Weiterbildungen dieses Verfahrens sind in den Unteransprüchen 2 und 3 gekennzeichnet. Ebenso wird diese Aufgabe gelöst durch ein Verfahren zur Herstellung eines Leistungshalbleitersubstrates mit mindestens einem Leistungshalbleiterbauelement gemäß Anspruch 4. Bevorzugte Aus- bzw. Weiterbildungen dieses erfindungsgemäßen Verfahrens sind in den Unteransprüchen 5 bis 8 gekennzeichnet.

Das erstgenannte Verfahren weist die folgenden Schritte auf:
- Beschichten mindestens einer Teilfläche eines flächigen Vorsinterträgers mit einer Sinterpaste,
- Trocknen der Sinterpaste,
- Anordnen eines Verbindungsflächenobjektes auf der zugehörigen Teilfläche der getrockneten Sinterpaste;
- Druck-Beaufschlagung des Gebildes aus dem mit der getrockneten Sinterpaste versehenen Vorsinterträger und dem Verbindungsflächenobjekt während einer kurzen Vorsinter-Zeitspanne, so dass die Haftkraft zwischen der getrockneten Sinterpaste und dem Verbindungsflächenobjekt größer wird als die Haftkraft zwischen der getrockneten Sinterpaste und dem Vorsinterträger,
- Entfernen des Vorsinterträgers von dem die getrocknete Sinterpaste aufweisenden Verbindungsflächenobjekt, so dass sich ein entsprechendes Halbzeug ergibt,
- Anordnen des Halbzeugs auf einem elektrisch isolierenden flächigen Grundkörper, wobei die getrocknete Sinterpaste dem flächigen Grundkörper zugewandt ist, und
- Sinter-Beaufschlagung des Gebildes aus dem Halbzeug und dem flächigen Grundkörper mit Druck und vorzugsweise erhöhter Temperatur während einer längeren Sinterzeitspanne zur Ausbildung des Leistungshalbleitersubstrates.

Das zweitgenannte Verfahren weist die folgenden Schritte auf:
- Beschichten mindestens einer Teilfläche eines flächigen ersten Vorsinterträgers mit einer Sinterpaste,
- Trocknen der Sinterpaste,
- Anordnen eines Verbindungsflächenobjektes auf der zugehörigen - Teilfläche der getrockneten Sinterpaste,
- Druck-Beaufschlagung des Gebildes aus dem mit der getrockneten Sinterpaste versehenen ersten Vorsinterträger und dem Verbindungsflächenobjekt während einer kurzen Vorsinter-Zeitspanne, so dass die Haftkraft zwischen der getrockneten Sinterpaste und dem Verbindungsflächenobjekt größer wird als die Haftkraft zwischen der getrockneten Sinterpaste und dem ersten Vorsinterträger,
- Entfernen des ersten Vorsinterträgers von dem die getrocknete Sinterpaste aufweisenden Verbindungsflächenobjekt, so dass sich ein entsprechendes Halbzeug ergibt,
- Beschichten mindestens einer Teilfläche eines zweiten Vorsinterträgers mit einer zweiten Sinterpaste,
- Trocknen der zweiten Sinterpaste,
- Anordnen des Halbzeugs, bestehend aus dem die erste getrocknete Sinterpaste aufweisenden Verbindungsflächenobjekt auf dem zweiten Vorsinterträger, wobei das Verbindungsflächenobjekt der getrockneten zweiten Sinterpaste zugewandt und die getrocknete erste Sinterpaste von der getrockneten zweiten Sinterpaste abgewandt ist,
- Druck-Beaufschlagung des Gebildes, bestehend aus dem zweiten Vorsinterträger und dem Verbindungsflächenobjekt sowie der ersten und der zweiten getrockneten Sinterpaste während einer kurzen Zeitspanne, so dass die Haftkraft zwischen der getrockneten zweiten Sinterpaste und dem Verbindungsflächenobjekt größer wird als die Haftkraft zwischen der getrockneten zweiten Sinterpaste und dem zweiten Vorsinterträger,
- Entfernen des zweiten Vorsinterträgers von dem Schichtengebilde, bestehend aus dem Verbindungsflächenobjekt, der getrockneten ersten und der davon abgewandten getrockneten zweiten Sinterpaste,
- Anordnen mindestens eines Halbleiterbauelementes auf der getrockneten ersten Sinterpaste des Schichtengebildes zur Ausbildung eines Bauelement-Halbzeugs,
- Anordnen des Bauelement-Halbzeugs auf einem elektrisch isolierenden, flächigen Grundkörper, wobei die getrocknete zweite Sinterpaste des Bauelement-Halbzeugs dem flächigen Grundkörper zugewandt und das mindestens eine Halbleiterbauelement vom flächigen Grundkörper abgewandt ist, und
- Sinter-Beaufschlagung des Gesamtgebildes aus dem Bauelement-Halbzeug und dem flächigen Grundkörper mit Druck und vorzugsweise erhöhter Temperatur während einer längeren Sinter-Zeitspanne.

Beide erfindungsgemäßen Verfahren weisen den Vorteil auf, dass ein elektrisch isolierender, flächiger Grundkörper mit einem Verbindungsflächenobjekt, bei dem es sich z.B. um schaltstrukturierte Leiterbahnen o.dgl. handelt und das aus einer Metalllage besteht, in einem Verfahren beidseitig mit Sinterpaste versehen und ggf. mit Bauelementen, insbesondere Leistungshalbleiterbauelementen, verbunden werden können. Der Druck der Sinterpaste erfolgt hierbei in vorteilhafter Weise nicht auf den jeweiligen Fügepartner, wie z.B. ein Leistungshalbleiterbauelement oder den Grundkörper, sondern auf einen Vorsinterträger. Der Vorsinterträger besteht beispielhaft aus Titan, und weist eine nicht sinterfähige Oberfläche auf, also eine Oberfläche mit der die Sinterpaste keine Sinterverbindung eingeht. Demgegenüber weist insbesondere das Verbindungsflächenobjekt und der Grundkörper sinterfähige Oberflächen, also vorzugsweise Edelmetalloberflächen, auf. Der Vorsinterträger kann gleichzeitig eine Bestückungshilfe für diskrete Bauelemente, wie Leistungshalbleiterbauelemente, bilden.

Weitere Einzelheiten, Merkmale und Vorteile der Erfindung ergeben sich aus der nachfolgenden Beschreibung in Verbindung mit den anliegenden Zeichnungen.

Es zeigen:

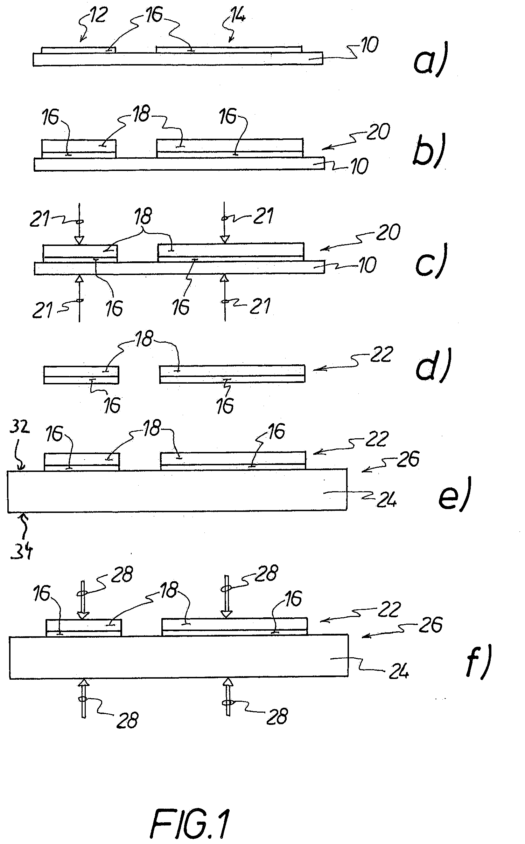

Figur 1 in einer schematischen Darstellung wesentliche, aufeinander folgende Verfahrensschritte zur Herstellung eines Leistungshalbleitersubstrates mit einem elektrisch isolierenden, flächigen Grundkörper, an dessen einer der beiden voneinander abgewandten Hauptflächen ein Verbindungsflächenobjekt fest haftend angebracht wird,

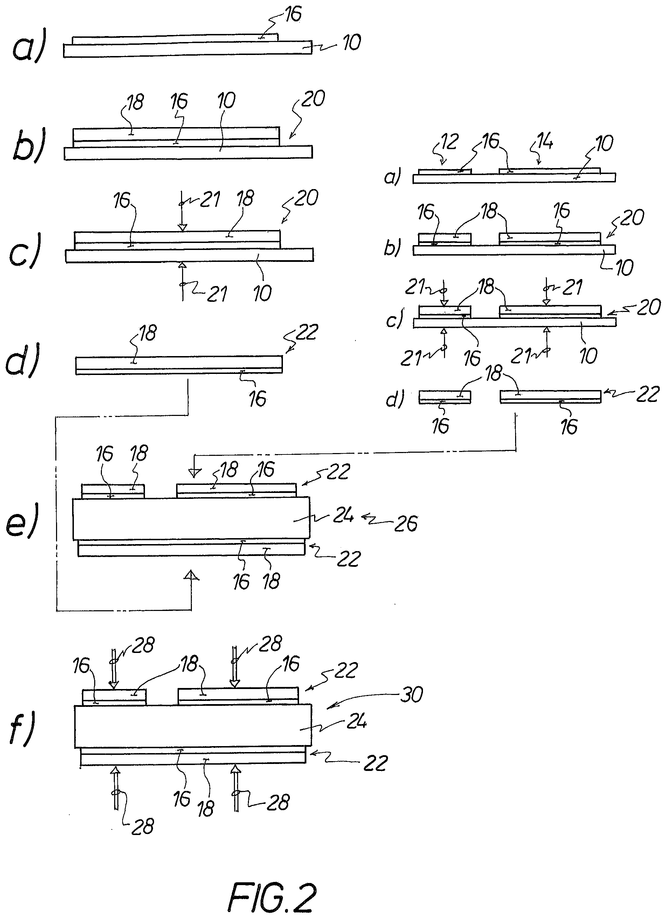

Figur 2 in einer der Figur 1 ähnlichen schematischen Darstellung die wesentlichen Verfahrensschritte zur Herstellung eines Leistungshalbleitersubstrates, das an seinen beiden voneinander abgewandten Hauptflächen jeweils fest haftend mit einem Verbindungsflächenobjekt versehen ist, und

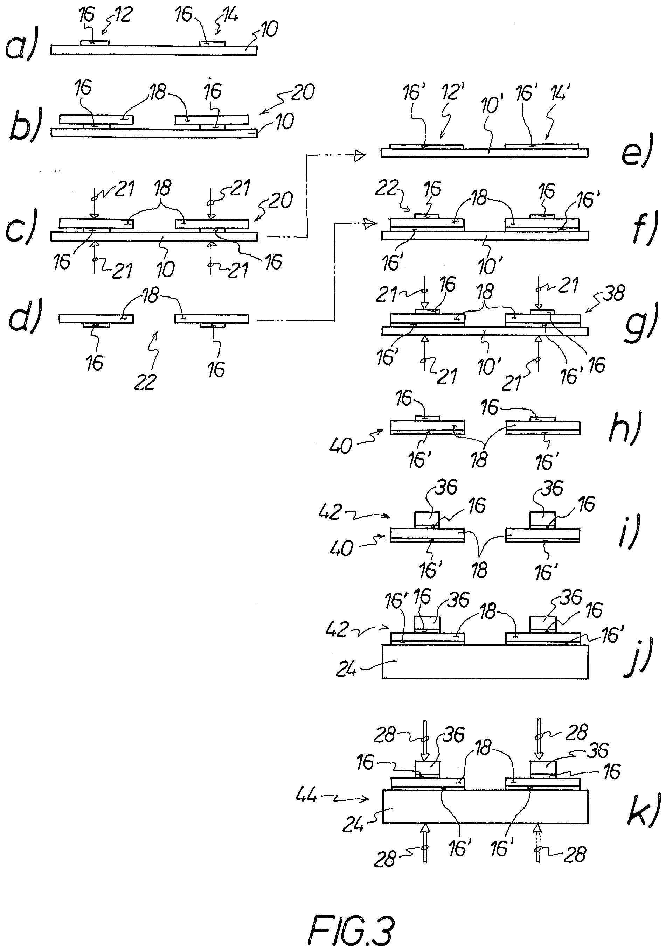

Figur 3 eine den Figuren 1 und 2 ähnliche Prinzipdarstellung der wesentlichen Verfahrensschritte des erfindungsgemäßen Verfahrens zur Herstellung eines Leistungshalbleitersubstrates mit Leistungshalbleiterbauelementen, wobei Leistungshalbleitersubstrat prinzipiell dem in Figur 1 gezeichneten Leistungshalbleitersubstrat ähnlich ist, es sich jedoch versteht, dass das Leistungshalbleitersubstrat auch dem in Figur 2 gezeichneten Leistungshalbleitersubstrat ähnlich ausgebildet sein kann.

Figur 1 verdeutlicht in einem Verfahrensschritt a) einen flächigen Vorsinterträger 10, der an Teilflächen 12 und 14 jeweils mit einer Sinterpaste 16 versehen wird. Das kann vorzugsweise durch Sieb- oder Schablonendruck erfolgen.

Die Sinterpaste 16 wird anschließend getrocknet. Nach dem Trocknen der Sinterpaste 16 wird auf den Teilflächen 12 und 14 der Sinterpaste 16 ein Verbindungsflächenobjekt 18 angeordnet. Das ist im Verfahrensschritt b) zeichnerisch dargestellt. Es kann hierbei auch bevorzugt sein, wenn das Verbindungsflächenelement auf seiner dem Vorsinterträger 10 abgewandten Seite bereits mit mindestens einem Leistungshalbleiterbauelement bestückt ist.

Anschließend erfolgt eine Druck- Beaufschlagung des Gebildes 20, bestehend aus dem mit der getrockneten Sinterpaste 16 versehenen Vorsinterträger 10 und dem auf der Sinterpaste 16 angeordneten Verbindungsflächenobjekt 18. Diese Druck- Beaufschlagung ist im Verfahrensschritt c) durch die einander zugewandten Pfeile 21 verdeutlicht. Diese Druck- Beaufschlagung des Gebildes 20 erfolgt bspw. mit einem Druck von 5MPa bis 30 MPa bei Raumtemperatur oder bei einer erhöhten Temperatur von bis zu 250°C während einer kurzen Zeitspanne von der Größenordnung eine Sekunde, so dass die Haftkraft zwischen der getrockneten Sinterpaste 16 und dem Verbindungsflächenobjekt 18 größer wird als die Haftkraft zwischen der getrockneten Sinterpaste und dem Vorsinterträger 10. Der Vorsinterträger 10 wird dann von dem die getrocknete Sinterpaste 16 aufweisenden Verbindungsflächenobjekt 18 entfernt, so dass sich ein Halbzeug 22 aus dem Verbindungsflächenobjekt 18 mit der getrockneten Sinterpaste 16 ergibt. Das Halbzeug 22 ist im Verfahrensschritt d) dargestellt.

Das Halbzeug 22 wird dann auf einem elektrisch isolierenden, flächigen Grundkörper 24 angeordnet, wobei die getrocknete Sinterpaste 16 dem Grundkörper 24 zugewandt ist und an diesem anliegt. Das ist im Verfahrensschritt e) dargestellt. Das Gebilde aus dem Halbzeug 22 und dem flächigen Grundkörper 24 ist mit der Bezugsziffer 26 bezeichnet.

Der Verfahrensschritt f) verdeutlicht mit den Pfeilen 28 die Sinter-Behandlung des Gebildes 26, bei der das Halbzeug 22 mit dem Grundkörper 24 fest verbunden wird, so dass sich ein erfindungsgemäß hergestelltes Leistungshalbleitersubstrat aus dem elektrisch isolierenden, flächigen Grundkörper 24 und dem Verbindungsflächenobjekt 18, bei dem es sich um schaltstrukturierte Leiterbahnen o. dgl. handelt, ergibt.

Wie aus den Verfahrensschritten b) bis f) ersichtlich ist, sind die Flächenabmessungen der Sinterpaste 16 und die Flächenabmessungen des zugehörigen Verbindungsflächenobjektes 18 bspw. aneinander angepaßt.

Figur 2 verdeutlicht die wesentlichen Verfahrensschritte zur Herstellung eines Leistungshalbleitersubstrates 30 mit einem elektrisch isolierenden, flächigen Grundkörper 24, auf dessen einer Hauptfläche 32 ein Verbindungsflächenobjekt 18 mit Flächenabmessungen angebracht ist, die kleiner sind als die Flächenabmessungen dieser Hauptfläche 32 des Grundkörpers 24. Auf der davon abgewandten Hauptfläche 34 des flächigen Grundkörpers 24 ist ein Halbzeug 22, bestehend aus einem Verbindungsflächenobjekt 18 und einer getrockneten Sinterpaste 16, mit Flächenabmessungen angeordnet, die an die Flächenabmessungen der Hauptfläche 34 des flächigen Grundkörpers 24 angepaßt sind. Das zuerst genannte Halbzeug 22 mit den kleineren Flächenabmessungen wird z.B. entsprechend den Verfahrensschritten a) bis e) gemäß Figur 1 hergestellt. Das Halbzeug 22 mit den an die Flächenabmessungen des flächigen Grundkörpers 24 angepaßten Flächenabmessungen wird gemäß den Verfahrensschritten a) bis d) gemäß Figur 2 hergestellt, wobei der Verfahrensschritt a) gemäß Figur 2 einen Vorsinterträger 10 bezeichnet, der großflächig mit einer Sinterpaste 16 beschicht wird. Die Sinterpaste 16 wird anschließend getrocknet. Auf der getrockneten Sinterpaste 16 wird ein entsprechend großflächiges Verbindungsflächenobjekt 18 angeordnet. Das ist in Figur 2 im Verfahrensschritt b) dargestellt. Der anschließende Verfahrensschritt c) verdeutlicht durch die einander zugewandten Pfeile 21 die Druck- Beaufschlagung des Gebildes 20 aus dem Vorsinterträger 10 und dem Verbindungsflächenobjekt 18 mit der zwischen diesen vorgesehenen getrockneten Sinterpaste 16. Durch diese Druck- Beaufschlagung des Gebildes 20 während einer kurzen Zeitspanne wird die Haftkraft zwischen der getrockneten Sinterpaste 16 und dem Verbindungsflächenobjekt größer als die Haftkraft zwischen der getrockneten Sinterpaste 16 und dem Vorsinterträger 10, so dass der Vorsinterträger 10 von dem großflächig mit der getrockneten Sinterpaste 16 versehenen großflächigen Verbindungsflächenobjekt 18 entfernt werden kann. Das ist im Verfahrensschritt d) gemäß Figur 2 verdeutlicht.

Das solchermaßen im Verfahrensschritt d) hergestellte Halbzeug 22 wird an der Hauptfläche 34 des elektrisch isolierenden, flächigen Grundkörpers 24 angeordnet, wobei die getrocknete Sinterpaste 16 dem flächigen Grundkörper 24 zugewandt ist, d.h. an der Hauptfläche 34 des Grundkörpers 24 anliegt. Das ist im Verfahrensschritt e) verdeutlicht. Anschließend erfolgt eine Sinter- Beaufschlagung des Gebildes 26, bestehend aus dem elektrisch isolierenden, flächigen Grundkörper 24 und den an dessen beiden voneinander abgewandten Hauptflächen 32 und 34 angebrachten Halbzeugen 22, bestehend aus den Verbindungsflächenobjekten 18 und den zugehörigen getrockneten Sinterpasten 16, mit Druck von vorzugsweise 10Mpa bis 50MPa und Temperatur von vorzugsweise 100°C bis 250°C während einer längeren Zeitspanne in der Größenordnung von einer Minute. Diese Sinter- Beaufschlagung ist in Figur 2 im Verfahrensschritt f) durch die Pfeile 28 angedeutet, so dass sich ein beidseitig mit Verbindungsflächenobjekten 18 ausgebildetes Leistungshalbleitersubstrat 30 ergibt.

Die Druck- Beaufschlagung der Sinterpaste erfolgt erfindungsgemäß also nicht auf das jeweils zu sinternde Bauteil sondern auf einen Vorsinterträger.

Figur 3 verdeutlicht schematisch die wesentlichen Verfahrensschritte des erfindungsgemäßen Verfahrens zur Herstellung eines Leistungshalbleitersubstrates mit Leistungshalbleiterbauelementen. Der Verfahrensschritt a) verdeutlicht hierbei wiederum einen Vorsinterträger 10, der an Teilflächen 12 und 14 jeweils mit einer Sinterpaste 16 beschichtet wird. Nach dem Trocknen der Sinterpaste 16 wird auf dieser ein Verbindungsflächenobjekt 18 angeordnet. Das entsprechende Gebilde 20 ist im Verfahrensschritt b) gezeichnet. Der Verfahrensschritt c) verdeutlicht eine durch die einander zugewandten Pfeile 21 angedeutete Druck-Beaufschlagung des Gebildes 20, bestehend aus dem mit der Sinterpaste 16 beschichteten Vorsinterträger 10 und dem Verbindungsflächenobjekt 18, so dass die Haftkraft zwischen der getrockneten Sinterpaste 16 und dem Verbindungsflächenobjekt 18 größer wird als die Haftkraft zwischen der Sinterpaste 16 und dem Vorsinterträger 10. Der Vorsinterträger 10 wird dann entfernt, so dass sich ein Halbzeug 22 ergibt, wie es im Verfahrensschritt d) gezeichnet ist.

Die Flächenabmessungen der Teilflächen 12 und 14 der Sinterpaste 16 sind kleiner als die Flächenabmessungen des Verbindungsflächenobjektes 18, wie aus den Figuren 3 b) bis 3 d) ersichtlich ist. Die Flächenabmessungen der Teilflächen 12 und 14 der Sinterpaste 16 sind an die Flächenabmessungen von Leistungshalbleiterbauelementen 36 angepaßt, wie sie weiter unten noch in Verbindung mit den Verfahrensschritten i) bis k) beschrieben werden.

Figur 3 e) zeigt den Verfahrensschritt, bei dem ein Vorsinterträger 10' an Teilflächen 12' und 14' mit einer Sinterpaste 16' beschichtet wird. Dabei können die Sinterpaste 16 und die Sinterpaste 16' selbstverständlich aus demselben Material bestehen.

Im anschließenden Verfahrensschritt f) wird das im Verfahrensschritt d) gezeichnete Halbzeug 22 auf dem mit der Sinterpaste 16 versehenen Vorsinterträger 10' derart angeordnet, dass das Verbindungsflächenobjekt 18 der Sinterpaste 16' zugewandt und die Sinterpaste 16 vom Vorsinterträger 10' abgewandt ist. Die Teilflächen 12' und 14' der Sinterpaste 16' weisen Flächenabmessungen auf, die an die Flächenabmessungen des Verbindungsflächenobjektes 18 angepaßt sind.

Figur 3 g) verdeutlicht den anschließenden Verfahrensschritt, bei welchem das Gebilde 38, bestehend aus dem Vorsinterträger 10', der getrockneten Sinterpaste 16' und dem Verbindungsflächenobjekt 18 mit der getrockneten Sinterpaste 16 bei Raumtemperatur oder bei einer höheren Temperatur während einer kurzen Zeitspanne mit Druck beaufschlagt wird. Diese Druck-Beaufschlagung ist durch die einander zugewandten Pfeile 21 verdeutlicht. Diese Druckbeaufschlagung mit oben genannten Parametern bewirkt, dass die Haftkraft zwischen der getrockneten Sinterpaste 16' und dem Verbindungsflächenobjekt 18 größer wird als die Haftkraft zwischen der Sinterpaste 16' und dem Vorsinterträger 10', so dass der Vorsinterträger 10' von dem Schichtengebilde 40, bestehend aus dem Verbindungsflächenobjekt 18 und den Sinterpasten 16 und 16' problemlos entfernt werden kann. Das ein entsprechendes Halbzeug bildende Schichtengebilde 40 ist in Figur 3 h) verdeutlicht.

Figur 3 i) zeigt den anschließenden Verfahrensschritt, bei welchem auf den Teilflächen 12 und 14 der getrockneten Sinterpaste 16 des besagten Halbzeugs, d.h. des Schichtengebildes 40 jeweils ein Leistungshalbleiterbauelement 36 angeordnet wird, so dass sich ein Bauelement-Halbzeug 42 ergibt. Das Bauelement-Halbzeug 42 wird dann auf einem elektrisch isolierenden, flächigen Grundkörper 24 angeordnet, wobei die relativ großflächige Sinterpaste 16' des Bauelement-Halbzeugs 42 dem Grundkörper 24 zugewandt ist, d.h. an diesem anliegt. Dieser Verfahrensschritt ist in Figur 3 j) dargestellt. Anschließend erfolgt gemäß dem Verfahrensschritt k) eine durch die einander zugewandt gezeichneten Pfeile 28 angedeutete Sinter-Beaufschlagung mit oben genannten Parametern des Gesamtgebildes 44, bestehend aus dem flächigen Grundkörper 24 und dem Bauelement-Halbzeug 42, mit Druck und Temperatur während einer längeren Sinter-Zeitspanne, so dass sich ein mit Leistungshalbleiterbauelementen 36 versehenes Leistungshalbleitersubstrat ergibt.

Alle mittels Sinterverbindungen zu verbindendenden Oberflächen aller Komponenteneiner weisen hier im Gegensatz zum Vorsinterträgers Edelmetalloberflächen auf.

## Patentansprüche

1. Verfahren zur Herstellung eines Leistungshalbleitersubstrates (30) mit den Verfahrensschritten:
• Beschichten mindestens einer Teilfläche (12, 14) eines flächigen Vorsinterträgers (10) mit einer Sinterpaste (16),
• Trocknen der Sinterpaste (16),
• Anordnen eines Verbindungsflächenobjektes (18) auf der zugehörigen Teilfläche (12, 14) der getrockneten Sinterpaste- (16),
• Druck-Beaufschlagung des Gebildes (20) aus dem mit der getrockneten Sinterpaste (16) versehenen Vorsinterträger (10) und dem Verbindungsflächenobjekt (18) während einer kurzen Vorsinter-Zeitspanne, so dass die Haftkraft zwischen der getrockneten Sinterpaste (16) und dem Verbindungsflächenobjekt (18) größer wird als die Haftkraft zwischen der getrockneten Sinterpaste (16) und dem Vorsinterträger (10),
• Entfernen des Vorsinterträgers (10) von dem die getrocknete Sinterpaste (16) aufweisenden Verbindungsflächenobjekt (18), so dass sich ein entsprechendes Halbzeug (22) ergibt,
• Anordnen des Halbzeugs (22) auf einem elektrisch isolierenden flächigen Grundkörper (24), wobei die getrocknete Sinterpaste (16) dem flächigen Grundkörper (24) zugewandt ist, und
• Sinter-Beaufschlagung des Gebildes (26) aus dem Halbzeug (22) und dem flächigen Grundkörper (24) mit Druck und vorzugsweise erhöhter Temperatur während einer längeren Sinterzeitspanne zur Ausbildung des Leistungshalbleitersubstrates (30).

2. Verfahren nach Anspruch 1,
**dadurch gekennzeichnet,**
**dass** die Flächenabmessungen der mindestens einen Teilfläche (12,14) der Sinterpaste (16) und die Flächenabmessungen des zugehörigen Verbindungsflächenorganes (18) aneinander angepaßt sind.

3. Verfahren nach Anspruch 1,
**dadurch gekennzeichnet,**
**dass** auf der einen Hauptfläche (32) des flächigen Grundkörpers (24) mindestens ein Halbzeug (22) mit Flächenabmessungen angeordnet wird, die kleiner sind als die Flächenabmessungen des flächigen Grundkörpers (24), und dass auf der davon abgewandten andere Hauptfläche (34) des flächigen Grundkörpers (24) ein Halbzeug (22) mit Flächenabmessungen angeordnet wird, die an die Flächenabmessungen des flächigen Grundkörpers (24) angepaßt sind.

4. Verfahren zur Herstellung eines Leistungshalbleitersubstrates (30) mit mindestens einem Leistungshalbleiterbauelement (36) mit den Verfahrensschritten:
• Beschichten mindestens einer Teilfläche (12, 14) eines flächigen ersten Vorsinterträgers (10) mit einer Sinterpaste (16),
• Trocknen der Sinterpaste (16),
• Anordnen eines Verbindungsflächenobjektes (18) auf der zugehörigen - Teilfläche (12, 14) der getrockneten Sinterpaste (16),
• Druck-Beaufschlagung des Gebildes (20) aus dem mit der getrockneten Sinterpaste (16) versehenen ersten Vorsinterträger (10) und dem Verbindungsflächenobjekt (18) während einer kurzen Vorsinter-Zeitspanne, so dass die Haftkraft zwischen der getrockneten Sinterpaste (16) und dem Verbindungsflächenobjekt (18) größer wird als die Haftkraft zwischen der getrockneten Sinterpaste (16) und dem ersten Vorsinterträger (10),
• Entfernen des ersten Vorsinterträgers (10) von dem die getrocknete Sinterpaste (16) aufweisenden Verbindungsflächenobjekt (18), so dass sich ein entsprechendes Halbzeug (22) ergibt,
• Beschichten mindestens einer Teilfläche (12', 14') eines zweiten Vorsinterträgers (10') mit einer zweiten Sinterpaste (16'),
• Trocknen der zweiten Sinterpaste (16'),
• Anordnen des Halbzeugs (22), bestehend aus dem die erste getrocknete Sinterpaste (16) aufweisenden Verbindungsflächenobjekt (10) auf dem zweiten Vorsinterträger (10'), wobei das Verbindungsflächenobjekt (18) der getrockneten zweiten Sinterpaste (16') zugewandt und die getrocknete erste Sinterpaste (16) von der getrockneten zweiten Sinterpaste (16') abgewandt ist,
• Druck-Beaufschlagung des Gebildes (38), bestehend aus dem zweiten Vorsinterträger (10') und dem Verbindungsflächenobjekt (18) sowie der ersten und der zweiten getrockneten Sinterpaste (16, 16') während einer kurzen Zeitspanne, so dass die Haftkraft zwischen der getrockneten zweiten Sinterpaste (16') und dem Verbindungsflächenobjekt (18) größer wird als die Haftkraft zwischen der getrockneten zweiten Sinterpaste (16') und dem zweiten Vorsinterträger (10'),
• Entfernen des zweiten Vorsinterträgers (10') von dem Schichtengebilde (40), bestehend aus dem Verbindungsflächenobjekt (18), der getrockneten ersten und der davon abgewandten getrockneten zweiten Sinterpaste (16, 16'),
• Anordnen mindestens eines Halbleiterbauelementes (36) auf der getrockneten ersten Sinterpaste (16) des Schichtengebildes (40) zur Ausbildung eines Bauelement-Halbzeugs (42),
• Anordnen des Bauelement-Halbzeugs (42) auf einem elektrisch isolierenden, flächigen Grundkörper (24), wobei die getrocknete zweite Sinterpaste (16') des Bauelement-Halbzeugs (42) dem flächigen Grundkörper (24) zugewandt und das mindestens eine Halbleiterbauelement (36) vom flächigen Grundkörper (24) abgewandt ist, und
• Sinter-Beaufschlagung des Gesamtgebildes (44) aus dem Bauelement-Halbzeug (42) und dem flächigen Grundkörper (24) mit Druck und vorzugsweise erhöhter Temperatur während einer längeren Sinter-Zeitspanne.

5. Verfahren nach Anspruch 4,
**dadurch gekennzeichnet,**
**dass** die Flächenabmessungen der mindestens einen Teilfläche (12, 14) aus der ersten Sinterpaste (16) kleiner sind als die Flächenabmessungen des zugehörigen Verbindungsflächenobjektes (18), und dass die Flächenabmessungen der mindestens einen zweiten Teilfläche (12', 14') aus der zweiten Sinterpaste (16') an die Flächenabmessungen des zugehörigen Verbindungsflächenobjektes (18) angepaßt sind.

6. Verfahren nach Anspruch 4 oder 5,
**dadurch gekennzeichnet,**
**dass** der erste Vorsinterträger (10) auch als zweiter Vorsinterträger (10') verwendet wird.

7. Verfahren nach einem der vorhergehenden Ansprüche,
**dadurch gekennzeichnet,**
**dass** die Druck-Beaufschlagung mit 5MPa bis 30 MPa Druck bei Raumtemperatur oder bei einer Temperatur bis 250°C während einer kurzen Zeitspanne von der Größenordnung einer Sekunde erfolgt, und dass die Sinter-Beaufschlagung mit 10MPa bis 50 MPa Druck bei einer Temperatur von 100°C bis 250°C während einer Sinter-Zeitspanne in der Größenordnung von einer Minute erfolgt.

8. Verfahren nach einem der vorhergehenden Ansprüche,
**dadurch gekennzeichnet,**
**dass** ein Verbindungsflächenobjekt (18) und ein Grundkörper (24) mit einer Edelmetalloberfläche verwendet werden.

## Claims

1. Method for manufacturing a power-semiconductor substrate (30) with the method steps of:
• coating at least a subarea (12, 14) of a sheet-like pre-sintering support (10) with a sintering paste (16) ,
• drying the sintering paste (16),
• arranging a connecting-area object (18) on the associated subarea (12, 14) of the dried sintering paste (16),
• applying pressure to the formation (20) comprising the pre-sintering support (10) provided with the dried sintering paste (16) and the connecting-area object (18) during a short pre-sintering time period, so that the bonding force between the dried sintering paste (16) and the connecting-area object (18) becomes greater than the bonding force between the dried sintering paste (16) and the pre-sintering support (10),
• removing the pre-sintering support (10) from the connecting-area object (18) having the dried sintering paste (16), so that a corresponding semifinished product (22) is obtained,
• arranging the semifinished product (22) on an electrically insulating sheet-like main body (24), the dried sintering paste (16) facing the sheet-like main body (24), and
• applying sintering pressure to the formation (2b) comprising the semifinished product (22) and the sheet-like main body (24) and preferably increased temperature during a longer sintering time period to form the power-semiconductor substrate (30).

2. Method according to Claim 1,
**characterized**
**in that** the area dimensions of the at least one subarea (12, 14) of the sintering paste (16) and the area dimensions of the associated connecting-area member (18) are adapted to one another.

3. Method according to Claim 1,
**characterized**
**in that** at least one semifinished product (22) with area dimensions that are smaller than the area dimensions of the sheet-like main body (24) is arranged on the one main area (32) of the sheet-like main body (24), and in that a semifinished product (22) with area dimensions that are adapted to the area dimensions of the sheet-like main body (24) is arranged on the other main area (34) of the sheet-like main body (24) that is facing away from said one main area.

4. Method for manufacturing a power-semiconductor substrate (30) comprising at least one power-semiconductor device (36) with the method steps of:
• coating at least a subarea (12, 14) of a sheet-like first pre-sintering support (10) with a sintering paste (16),
• drying the sintering paste (16),
• arranging a connecting-area object (18) on the associated subarea (12, 14) of the dried sintering paste (16),
• applying pressure to the formation (20) comprising the first pre-sintering support (10) provided with the dried sintering paste (16) and the connecting-area object (18) during a short pre-sintering time period, so that the bonding force between the dried sintering paste (16) and the connecting-area object (18) becomes greater than the bonding force between the dried sintering paste (16) and the first pre-sintering support (10),
• removing the first pre-sintering support (10) from the connecting-area object (18) having the dried sintering paste (16), so that a corresponding semifinished product (22) is obtained,
• coating at least a subarea (12', 14') of a second pre-sintering support (10') with a second sintering paste (16'),
• drying the second sintering paste (16'),
• arranging the semifinished product (22), consisting of the connecting-area object (10) having the first dried sintering paste (16), on the second pre-sintering support (10'), the connecting-area object (18) facing the dried second sintering paste (16') and the dried first sintering paste (16) facing away from the dried second sintering paste (16'),
• applying pressure to the formation (38), consisting of the second pre-sintering support (10') and the connecting-area object (18) and also the first and second dried sintering pastes (16, 16'), during a short time period, so that the bonding force between the dried second sintering paste (16') and the connecting-area object (18) becomes greater than the bonding force between the dried second sintering paste (16') and the second pre-sintering support (10'),
• removing the second pre-sintering support (10') from the layered formation (40), consisting of the connecting-area object (18), the dried first sintering paste (16) and the dried second sintering paste (16') facing away therefrom,
• arranging at least one semiconductor device (36) on the dried first sintering paste (16) of the layered formation (40) to form a semifinished device product (42) ,
• arranging the semifinished device product (42) on an electrically insulating, sheet-like main body (24), the dried second sintering paste (16') of the semifinished device product (42) facing the sheet-like main body (24) and the at least one semiconductor device (36) facing away from the sheet-like main body (24), and
• applying sintering pressure to the entire formation (44) comprising the semifinished device product (42) and the sheet-like main body (24) and preferably increased temperature during a longer sintering time period.

5. Method according to Claim 4,
**characterized**
**in that** the area dimensions of the at least one subarea (12, 14) comprising the first sintering paste (16) are smaller than the area dimensions of the associated connecting-area object (18), and in that the area dimensions of the at least one second subarea (12', 14') comprising the second sintering paste (16') are adapted to the area dimensions of the associated connecting-area object (18).

6. Method according to Claim 4 or 5,
**characterized**
**in that** the first pre-sintering support (10) is also used as the second pre-sintering support (10').

7. Method according to one of the preceding claims,
**characterized**
**in that** the application of pressure is performed with 5 MPa to 30 MPa of pressure at room temperature or at a temperature up to 250°C during a short time period of the order of magnitude of a second, and in that the application of sintering pressure is performed with 10 MPa to 50 MPa of pressure at a temperature of 100°C to 250°C during a sintering time period of the order of magnitude of a minute.

8. Method according to one of the preceding claims,
**characterized**
**in that** a connecting-area object (18) and a main body (24) with a high-grade metal surface are used.

## Revendications

1. Procédé de fabrication d'un substrat (30) pour semi-conducteur de puissance, le procédé comportant les étapes qui consistent à :
revêtir d'une pâte de frittage (16) au moins une partie (12, 14) de la surface d'un support (10) plat de pré-frittage,
sécher la pâte de frittage (16),
disposer un objet plat de liaison (18) sur la surface partielle (12, 14) concernée de la pâte de frittage (16) séchée,
appliquer une pression sur l'ensemble (20) constitué du support (10) de pré-frittage doté de la pâte de frittage (16) séchée et de l'objet plat de liaison (18) pendant une courte durée de pré-frittage de telle sorte que la force d'adhérence entre la pâte de frittage (16) séchée et l'objet plat de liaison (18) soit supérieure à la force d'adhérence entre la pâte de frittage (16) séchée et le support (10) de pré-frittage,
enlever le support (10) de pré-frittage de l'objet plat de liaison (18) présentant la pâte de frittage (16) de manière à former l'ébauche (22) correspondante, placer l'ébauche (22) sur un corps de base plat (24) électriquement isolant, la pâte de frittage (16) étant tournée vers le corps de base plat (24),
réaliser le frittage de l'ensemble (26) constitué de l'ébauche (22) et du corps de base plat (24) en appliquant une pression et de préférence une température élevée pendant une durée de frittage assez longue de manière à former le substrat (30) pour semi-conducteur de puissance.

2. Procédé selon la revendication 1, **caractérisé en ce que** les dimensions de la surface de la ou des parties (12, 14) de la surface de la pâte de frittage (16) et les dimensions de la surface de l'organe associé de surface de liaison (18) sont adaptées l'une à l'autre.

3. Procédé selon la revendication 1, **caractérisé en ce qu'**au moins une ébauche (22) dont les dimensions de surface sont inférieures aux dimensions de surface du corps de base plat (24) est disposée sur une des surfaces principales (32) du corps de base plat (24) et **en ce qu'**une ébauche (22) dont les dimensions de surface sont adaptées aux dimensions de surface du corps de base plat (24) est disposée sur l'autre surface principale (34) du corps de base plat (24), non tournée vers elle.

4. Procédé de fabrication d'un substrat (30) pour semi-conducteur de puissance présentant au moins un composant semi-conducteur de puissance (36), le procédé comportant les étapes suivantes :
revêtir d'une pâte de frittage (16) au moins une partie (12, 14) de la surface d'un premier support (10) plat de pré-frittage,
sécher la pâte de frittage (16),
disposer un objet plat de liaison (18) sur la surface partielle (12, 14) concernée de la pâte de frittage (16) séchée,
appliquer une pression sur l'ensemble (20) constitué du premier support (10) de pré-frittage doté de la pâte de frittage (16) séchée et de l'objet plat de liaison (18) pendant une courte durée de pré-frittage de telle sorte que la force d'adhérence entre la pâte de frittage (16) séchée et l'objet plat de liaison (18) soit supérieure à la force d'adhérence entre la pâte de frittage (16) séchée et le premier support (10) de pré-frittage,
enlever le premier support (10) de pré-frittage de l'objet plat de liaison (18) présentant la pâte de frittage (16) de manière à former l'ébauche (22) correspondante,
revêtir d'une deuxième pâte de frittage (16') au moins une partie (12', 14') d'un deuxième support (10') de pré-frittage,
sécher la deuxième pâte de frittage (16'),
placer l'ébauche (22) constituée de l'objet plat de liaison (10) présentant la première pâte de frittage (16) séchée sur le deuxième support (10') de pré-frittage, l'objet plat de liaison (18) étant tourné vers la deuxième pâte de frittage (16') séchée et la première pâte de frittage (16) séchée n'étant pas tournée vers l'objet plat de liaison (18),
appliquer une pression sur l'ensemble (38) constitué du deuxième support (10') de pré-frittage, de l'objet plat de liaison (18), de la première et de la deuxième pâte de frittage (16, 16') séchées pendant un court laps de temps de telle sorte que la force d'adhérence entre la deuxième pâte de frittage (16') séchée et l'objet plat de liaison (18) soit supérieure à la force d'adhérence entre la deuxième pâte de frittage (16') séchée et le deuxième support (10') de pré-frittage,
enlever le deuxième support (10') de pré-frittage de l'ensemble de couches (40) constitué de l'objet plat de liaison (18), de la première et de la deuxième pâte de frittage (16, 16') séchées,
placer au moins un composant semi-conducteur (36) sur la première pâte de frittage (16) séchée de l'ensemble de couches (40) pour former une ébauche de composant (42),
placer l'ébauche de composant (42) sur un corps de base plat (24) électriquement isolant, la deuxième pâte de frittage (16') séchée de l'ébauche de composant (42) étant tournée vers le corps de base plat (24) et le ou les composants semi-conducteurs (36) n'étant pas tournés vers le corps de base plat (24), et
réaliser le frittage de l'ensemble (44) constitué de l'ébauche de composant (42) et du corps de base plat (24), à une pression et de préférence une température élevées, pendant une durée de frittage assez longue.

5. Procédé selon la revendication 1, **caractérisé en ce que** les dimensions de la surface de la ou des parties (12, 14) de la surface de la première pâte de frittage (16) et les dimensions de la surface de l'organe associé de surface de liaison (18) sont adaptées l'une à l'autre et **en ce que** les dimensions en surface de la ou des parties de surface (12', 14') de la deuxième pâte de frittage (16') sont adaptées aux dimensions de surface de l'objet plat de liaison (18) associé.

6. Procédé selon les revendications 4 ou 5, **caractérisé en ce que** le premier support de pré-frittage (10) est également utilisé comme deuxième support de pré-frittage (10').

7. Procédé selon l'une des revendications précédentes, **caractérisé en ce que** l'application d'une pression s'effectue sous 5 MPa à 30 MPa de pression à température ambiante ou à une température pouvant atteindre 250°C pendant un court laps de temps de l'ordre d'une seconde et **en ce que** l'application du frittage s'effectue sous une pression de 10 MPa à 50 MPa à une température de 100°C à 250°C pendant un intervalle de temps de frittage de l'ordre d'une minute.

8. Procédé selon l'une des revendications précédentes, **caractérisé en ce qu'**il utilise un objet plat de liaison (18) et un corps de base (24) dotés d'une surface en métal précieux.
